# EUROPÄISCHE PATENTSCHRIFT

(11) **EP 2 983 246 B1**
(45) Veröffentlichungstag und Bekanntmachung des Hinweises auf die Patenterteilung: **04.03.2020**
(21) Anmeldenummer: 14179926.2
(22) Anmeldetag: 05.08.2014
(51) Int. Cl.: H01R 12/71, H01R 12/75, H05K 1/02, H01R 12/70, H01R 12/88

(54) **Elektrische Verbindungsanordnung**
Electric connection assembly
Système de raccordement électrique

(43) Veröffentlichungstag der Anmeldung: 10.02.2016
(73) Patentinhaber: Aptiv Technologies Limited, St. Michael (BB)
(72) Erfinder: Stoermer, Peter, 42859 Remscheid (DE)
(74) Vertreter: Manitz Finsterwald Patent- und Rechtsanwaltspartnerschaft mbB

(56) Entgegenhaltungen:
- EP-A1- 2 259 312
- EP-A1- 2 362 719
- DE-A1-102008 040 290
- DE-A1-102010 062 410
- US-A- 4 420 206
- US-A- 5 953 214
- US-A1- 2012 081 859
- US-A1- 2012 149 249
- US-B1- 7 510 418

## Beschreibung

Die Erfindung betrifft eine elektrische Verbindungsanordnung, zum elektrischen Verbinden eines Kabels und einer Leiterplatte.

### TECHNISCHER HINTERGRUND DER ERFINDUNG

Bei modernen Kraftfahrzeugen, insbesondere Elektrofahrzeugen, sind zum Betrieb der Fahrzeuge große elektrische Ströme notwendig. Diese großen Ströme werden im Kabelsatz des Fahrzeugs durch entsprechend groß dimensionierte Leitungen, zwischen Batterie und Verbraucher, transportiert. Um die elektrischen Verluste, die durch den Widerstand der Leitungen, hervorgerufen werden gering zu halten, werden Leitungen mit großen Querschnitten eingesetzt. Der Einsatz von leichten Aluminiumleitungen erhöht die Leitungsquerschnitte zusätzlich. Die Ströme werden durch Halbleiterbauelemente, die sich in Steuergeräten (ECU) befinden, gesteuert. Der Begriff Steuergerät wird in der Fahrzeugtechnik allgemeinen als Sammelbegriff für, in Gehäusen verteilten, elektrischen Einheiten, verwendet. Die Halbleiterbauelemente sind üblicherweise auf Leiterplatten angeordnet, auf denen sich auch andere elektronische Bauteile befinden. Um die Leiterplatten und die darauf angeordneten Bauelemente mit dem Bordnetz zu verbinden sind üblicherweise Kontaktelemente an der Leiterplatte vorgesehen. Diese können mit Gegenkontakten, die an den Enden der Kabel, des Leitungssatzes angeordnet sind, verbunden werden. In Fahrzeugen ist der Bauraum naturgemäß knapp bemessen. Deshalb sind im Allgemeinen die Kontakte an den Rändern der Leiterplatte angebracht um ein flaches Design des Steuergerätes zu ermöglichen. Dieser Umstand erfordert es, dass die Steckkontakte so ausgeführt werden müssen, dass sie an der Gehäusewand für die Kontakt Teile des Kabelsatzes erreichbar sind. Die Kontaktteile weisen, zum Schutz, eine Umhüllung aus Kunststoff auf. Diese Buchse am Steuergerät wird im Allgemeinen als "Header" bezeichnet. Die Kontaktteile an den Kabelenden des Kabelsatzes sind in einem Steckergehäuse integriert. Diese Art der elektrischen Kontaktierung von Kabelsatz und Steuergerät hat sich in der Fahrzeugtechnik seit vielen Jahren bewährt. Allerdings gelang sie an ihre Grenzen, wenn die zu übertragenen Ströme in Größenordnungen vordringen, wie sie bei Elektrofahrzeugen standardmäßig auftreten. Die Übergangswiderstände an diesen Kontaktsystemen sind signifikant, sie verbrauchen elektrische Energie, die sie in Wärme umwandeln. Kontaktelemente für große Stromdichten weisen bei relativ niedrigen Widerstand großer Abmessungen auf, da der der Widerstand des Strompfads nicht zu groß werden darf. Große Kontaktelemente erfordern große Stecker und entsprechende Buchsen. Dieses vergrößert den Platzbedarf für die Steuergeräte. Ein weiteres Problem findet sich in den Steuergeräten selbst. Dort entsteht, durch die großen Ströme, die durch die elektrischen Bauteile fließen, eine nicht zu unterschätzende Wärmebelastung. Diese Wärme muss über thermisch gut leitfähige Elemente, die an den hitzeerzeugenden Elementen angebracht sind, an das Gehäuse und an die Umgebung geleitet werden. Dokument DE102010062410A1 offenbart eine verbesserte Wärmesenke zum Abführen von übermäßiger Wärme, die durch die elektronischen Bauelemente auf einer Leiterplatte erzeugt wird. Oder es müssen passive und/oder aktive Lüftungssysteme vorgesehen werden, die Luft zum kühlen in das Gehäuse führen und die erhitzte Luft herausführen. Diese Notwendigkeit zu kühlen macht die Steuergeräte größer, schwerer und teurer.

Der Erfindung liegt die Aufgabe zu Grunde ein Verbindungssystem bereitzustellen, dass bei niedrigem elektrischem Widerstand, die Leitungen eines Kabelsatzes mit der Leiterplatte und den darauf befindlichen elektrischen Bauteilen eines Steuergerätes elektrisch verbindet. Zusätzlich sollte das Verbindungssystem die Kühlung des Steuergerätes unterstützen.

### BESCHREIBUNG DER ERFINDUNG

Die Aufgabe wird durch eine Verbindungsanordnung nach Anspruch 1 gelöst.

Eine Verbindungsanordnung zum Übertragen großer elektrischer Ströme zum Betrieb von Elektrofahrzeugen, umfassend eine Leiterplatte, ein Halbleiterbauelement angeordnet auf einer ersten Oberfläche einer ersten Seite der Leiterplatte, ein Verbindungsmittel angeordnet auf einer zweiten Oberfläche einer zweiten Seite der Leiterplatte, ein Kontaktelement kontaktierbar mit dem Verbindungsmittel und einer elektrischen Leitung eines Kabelsatzes eines Elektrofahrzeugs, wobei das Verbindungsmittel, gegenüber dem Halbleiterbauelement angeordnet ist. In der Technik verwendete Leiterplatten verwenden ein Aufbau bei dem ein Trägermaterial mit einer elektrisch leitfähigen Beschichtung versehen ist. Es kann eine Seite oder auch beide Seiten elektrisch beschichtet ein. Üblicherweise werden Bereiche die nicht leitfähig sein sollen vom Trägermaterial entfernt. Die Position des Verbindungmittels, das hier aus einem Teil der leitfähigen Beschichtung hergestellt wird, wird auf der Leiterplatte so gewählt, dass es, gegenüber einem Halbleiterbauelement angeordnet ist. Der Begriff "gegenüber", ist hier wie folgt zu verstehen. Das Verbindungsmittel ist so auf der Leiterplatte angeordnet, dass wenn das Trägermaterial der Leiterplatte entfernt werden würde, das Halbleiterbauelement auf dem Verbindungsmittel aufliegen würde. Oder anders ausgedrückt, eine virtuelle Achse, die durch den Mittelpunkt des Halbleiterbauelements und senkrecht durch die Leiterplatte dringt, durchdringt auch das Verbindungsmittel. Dieses hat den Effekt, dass die vom Halbleiterbauelement erzeugte Wärme, durch die Leiterplatte hindurch, auf das Verbindungsmittel geleitet wird. Von dort aus kann die Wärme über das Kontaktelement direkt an die Umgebung abgegeben und auch in den elektrischen Leiter geführt werden. Dadurch kann ein Teil der unerwünschten Wärme aus dem Steuergerät heraus in den Leitungssatz transportiert werden, von wo aus er an die Umwelt abgegeben wird.

Erfindungsgemäß ist das Verbindungsmittel aus einem Teil der leitfähigen Beschichtung der Leiterplatte gebildet. So ist das Verbindungsmittel bereits nach dem Herstellungsverfahren der Leiterplatte fest mit der Leiterplatte verbunden. Die Geometrie des Verbindungmittels lässt sich leicht auf benötigte Stromdichte und Kontaktelement Geometrie anpassen. Beim Anbringen eines angepassten Kontaktelements an die Leiterplatte wird eine große Fläche des Kontaktelements mit einer großen Fläche der leitfähigen Beschichtung der Leiterplatte elektrisch verbunden. Durch die großflächige Verbindung der beiden, elektrisch leitfähigen, Flächen wird ein niedriger Übergangswiderstand erreicht. An diesem niedrigen Übergangswiderstand wird, auch bei größeren Stromdichten, wenig Wärme erzeugt.

Besonders bevorzugt ist das Halbleiterbauelement und das gegenüberliegende Verbindungsmitte beabstandet vom Rand der Leiterplatte angeordnet. Die Verbindungsanordnung ermöglicht optimale Design-Freiheit für das Layout der Leiterplatte, da sich die Steckeranschlüsse nicht mehr an den Seiten der Leiterplatte befinden müssen.

Bevorzugt ist ein zweites Halbleiterbauelement auf der ersten Oberfläche, der ersten Seite, der Leiterplatte angeordnet und elektrisch mit dem Kontaktelement verbindbar. Dadurch kann das erstes Halbleiterbauelement durch das Kontaktelement, das sich gegenüber dem ersten Halbleiterelement befindet, gekühlt werden. Wohingegen das zweite Halbleiterbauelement, das sich nicht gegenüber befindet, mit Strom versorgt wird, ohne gekühlt zu werden. Dadurch wird die thermische Planung der Steuereinheit vereinfacht. Elektrische und thermische Belange können getrennt betrachtet werden.

Besonders bevorzugt ist das Halbleiterbauelement, zumindest mit einem Teil der leitfähigen Beschichtung, die sich zwischen dem Halbleiterbauelement und Trägermaterial der Leiterplatte erstreckt, elektrisch verbunden. Dadurch läßt sich das thermische und elektrische Verhalten der Schaltung einfacher planen. Die erste leitfähige Beschichtung wird auch zur Wärmeleitung genutzt. Das Halbleiterbauelement kann die Wärme schnell in die leitfähige Beschichtung abgeben. Von dort aus diffundiert die Wärme durch das Trägermaterial zum Verbindungsmittel. Um die Kühlwirkung zu vergrößern kann die erste leitfähige Beschichtung größer, als die Abmessungen des Halbleiterbauelements, gewählt werden. Der Wärmetransport durch das Trägermaterial wird besser je größer die Flächen sind.

Bevorzugt ist die Fläche des Verbindungsmittels größer als die Fläche der leitfähigen Beschichtung der Leiterplatte, die zwischen Halbleiterbauelement und Trägermaterial angeordnet ist. Dadurch vergrößert sich der Bereich mit einem höheren Wärmeleitwert in der Nähe des Halbleiterbauelements, wodurch der Bereich besser gekühlt wird.

Bevorzugt weist die Leiterplatte, im Bereich zwischen Halbleiterbauelement und Kontaktelement, mindestens eine Durchkontaktierung. Diese reduziert den elektrischen und thermischen Widerstand zwischen den leitfähigen Beschichtungen der Leiterplatte. Die Durchkontaktierung wird üblicherweise durchgeführt, indem ein Niet, in einer Bohrung des Trägermaterials, der Leiterplatte, befestigt wird. Die Bohrung verläuft üblicherweise senkrecht zu den Flächen. Daraus ergibt sich der kürzeste Weg für Strom und Wärme.

Besonders bevorzugt weist das Kontaktelement eine ebene Fläche auf, die dazu ausgebildet ist, mit dem Verbindungsmittel eine elektrische Verbindung zu erzeugen. Beim Anbringen des Kontaktelements an die Leiterplatte wird eine große Fläche des Kontaktelements mit einer großen Fläche der leitenden Beschichtung der Leiterplatte elektrisch verbunden. Durch die großflächige Verbindung der beiden, elektrisch leitfähigen, Flächen wird ein niedriger Übergangswiderstand erreicht. An diesem niedrigen Übergangswiderstand wird, auch bei größeren Stromdichten, wenig Wärme erzeugt.

Bevorzugt weist das Kontaktelement Mittel zur Kühlung auf. Das Kontaktelement kann mittels Fluiden gekühlt werden. Es kann Kühlrippen aufweisen oder massiv ausgebildet sein. Bei massiver Ausgestaltung können Bohrungen oder Kanäle vorgesehen werden, durch die ein Kühlmittel fließen kann. Es können auch thermisch leitfähige Elemente vom Kontaktelement ragen, die mit dem Gehäuse des Steuergerätes oder anderen zur Kühlung verwendeten Elementen verbunden sind. Ein gekühltes Kontaktelement kann die Kühlleistung für ein Halbleiterbauelement zusätzlich erhöhen.

Bevorzugt weist die Verbindungsanordnung Haltemittel auf, die das Kontaktelement und das Verbindungsmittel lösbar zusammenhalten. Als Haltemittel können alle mechanischen Vorrichtungen dienen, die dazu in der Lage sind das Kontaktelement und das Verbindungsmittel zusammen zu halten. Vorausgesetzt, dass eine gute elektrische und thermische Verbindung gewährleistet ist.

Besonders bevorzugt ist das Haltemittel so ausgebildet, dass bei Betätigung des Haltemittels, das Kontaktelement gegen das Verbindungsmittel gedrückt wird und ein Teil des Haltemittels gegen das Halbleiterbauelement gedrückt wird. Dadurch wird gewährleistet, dass die Kontaktflächen eng aneinander liegen und einen niedrigen Widerstand aufweisen. Außerdem kühlt das Haltemittel zusätzlich das Halbleiterbauelement.

Bevorzugt ist das Haltemittel im Querschnitt U-Förmig und an einem der Schenkel ist ein Exzenter angebracht. Der Exzenter ist in den Raum zwischen den Schenkeln schwenkbar. Der Exzenter schwenkt in den Raum zwischen den Schenkeln und drückt Materie, die sich dazwischen befindet, zum gegenüberliegenden Schenkel. Befindet sich zwischen den Schenkeln die Leiterplatte und das Kontaktelement werden diese Teile vom Exzenter gegen den zweiten Schenkel gedrückt. An dem Exzenter ist ein Hebel angebracht mit dem der Exzenter geschwenkt werden kann. Diese Anordnung ist leicht zu bedienen und arbeitet zuverlässig.

Bevorzugt weist das Haltemittel Mittel zur Kühlung auf. Das Haltemittel kann mittels Fluiden gekühlt werden. Es kann Kühlrippen aufweisen oder massiv ausgebildet sein. Bei massiver Ausgestaltung können Bohrungen oder Kanäle vorgesehen werden, durch die ein Kühlmittel fließen kann. Es können auch thermisch leitfähige Elemente vom Haltemittel ragen, die mit dem Gehäuse des Steuergerätes oder anderen zur Kühlung verwendeten Elementen verbunden sind.

Bevorzugt ist die Verbindungsanordnung für Hochstromanwendungen geeignet.

### KURZBESCHREIBUNG DER ABBILDUNGEN

Nachfolgend wird die Erfindung anhand einer vorteilhaften Ausführungsform rein beispielhaft unter Bezugnahme auf die beigefügten Zeichnungen beschrieben. Es zeigen:
Fig. 1 zeigt eine Verbindungsanordnung aus dem Stand der Technik.
Fig. 2 zeigt eine Ansicht auf die erste Seite der Leiterplatte.
Fig. 3 zeigt eine Ansicht auf die zweite Seite der Leiterplatte.
Fig. 4 zeigt ein Kontaktelement an dem eine elektrische Leitung befestigt ist.
Fig. 5 zeigt ein Kontaktelement das an der zweiten Seite der Leiterplatte angebracht ist.
Fig. 6A zeigt eine Seitenansicht des Kontaktelements.
Fig. 6B zeigt eine weitere Seitenansicht des Kontaktelements.
Fig. 7 Zeigt eine Schnittdarstellung der Figur 5.
Fig. 8 Zeigt eine Schnittdarstellung einer Leiterplatte mit angebrachtem Kontaktelement und zwei Halbleiterbauelementen.

### BESCHREIBUNG EINES AUSFÜHRUNGSBEISPIELS

Im Folgenden werden bevorzugte Ausgestaltungen der Erfindung näher beschrieben. Ähnliche oder korrespondierende Einzelheiten des erfindungsgemäßen Gegenstandes sind mit denselben Bezugszeichen versehen.

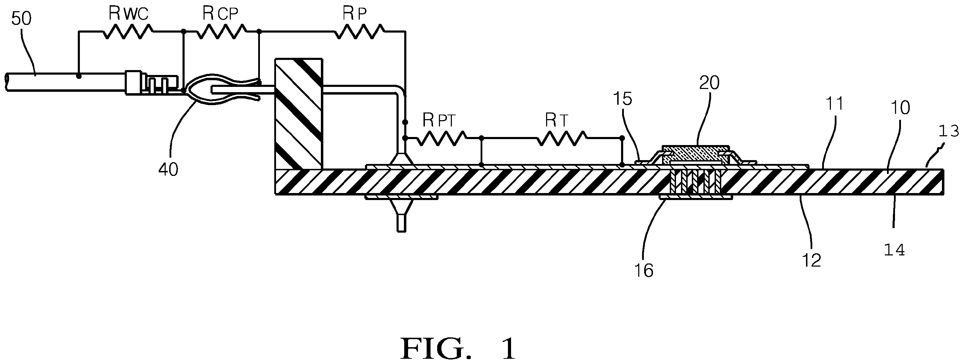

Figur 1 zeigt ein Verbindungsaufbau aus dem Stand der Technik in einer Schnittdarstellung. Auf einer einer Leiterplatte 10 ist ein Halbleiterbauelement 20 angeordnet, die Leiterplatte 10 ist über ein Kontaktelement 40 mit einem elektrischen Leiter 50 elektrisch verbunden. Die Leiterplatte 10 verfügt auf der ersten Oberfläche 13, einer ersten Seite 11, über eine erste leitfähige Beschichtung 15. Sowie auf einer zweiten Oberfläche 14, einer zweiten Seite 12, über eine zweite leitfähige Beschichtung 16. Das Halbleiterbauelement 20 wird über den elektrischen Leiter 50, das Kontaktelement 40, die leitfähigen Beschichtungen 15,16 mit Strom versorgt. Die elektrischen Widerstände, die sich dem Stromfluss entgegen setzen, sind mit dem Bezugszeichen Rwc, Rcp, Rp, Rpt und Rt bezeichnet. In dieser Darstellung ist gut zu sehen, dass der elektrische Strom viele Teilwiderstände überwinden muss um das Halbleiter Bauelemente zu erreichen.

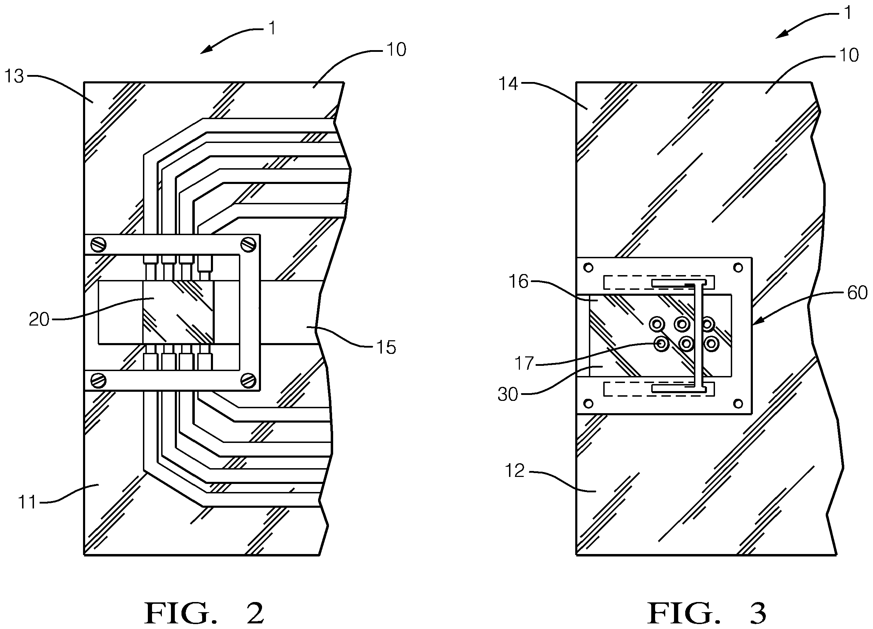

Figur 2 zeigt die erste Seite 11 der erfinderischen Verbindungsanordnung. Auf der ersten Oberfläche 13 ist ein Halbleiterbauelement 20 angebracht und mit Teilen der ersten leitfähigen Beschichtung 15 elektrisch verbunden.

Figur 3 zeigt die zweite Seite 12 der erfinderischen Verbindungsanordnung. Auf der zweiten Oberfläche 14 ist die zweite leitfähige Beschichtung 16 dargestellt. Aus einem Teilbereich der zweiten Leitfäden Beschichtung 16 wird ein Verbindungsmittel 30 erzeugt. Dieses passiert schon bei der Herstellung der Leiterplatte 10. Das Verbindungsmittel 30 wird beim Ätzen oder Fräsen der Leiterbahnen erzeugt. Die Form des Verbindungmittels 30 korrespondiert mit der Form eines Kontaktbereichs 41 des Kontaktelements 40. Die Form und Größe des Kontaktbereichs 41 sollte so gewählt werden, dass die Oberflächen nicht wesentlich überlappen, wenn der Kontaktbereich 41 mit dem Verbindungsmittel 30 kontaktiert wird. Nur dort wo Kontaktbereich 41 und Verbindungsmittel 30 miteinander verbunden sind, wird optimal Strom und Wärme transportiert.

Im Bereich des Verbindungmittels 30 sind Durchkontaktierungen 17 dargestellt, die eine elektrische Verbindung zwischen der ersten elektrisch leitfähigen Beschichtung 15 und der zweiten elektrisch leitfähigen Beschichtung 16 herstellen. Die Durchkontaktierungen 17 sind in Figur 2 nicht sichtbar, da sie vom Halbleiterbauelemente 20 verdeckt sind. Ein Haltemittel 60, das später genauer erläutert wird, ist ebenfalls in Figur 3 dargestellt.

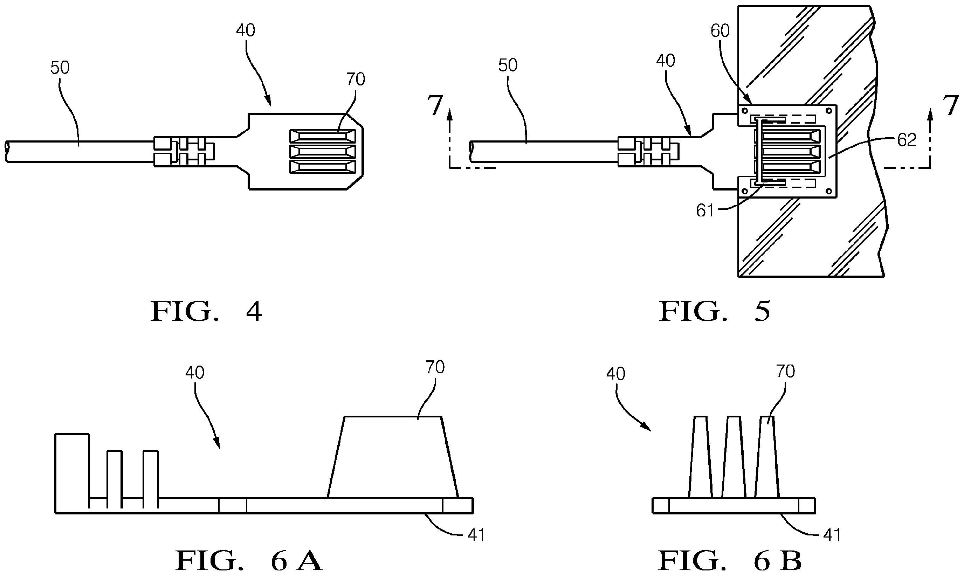

Figur 4 zeigt das Kontaktelement 40 in einer Draufsicht. Der elektrische Leiter 50 ist mit dem Kontaktelement 40 mittels einer Crimp-Verbindung verbunden.

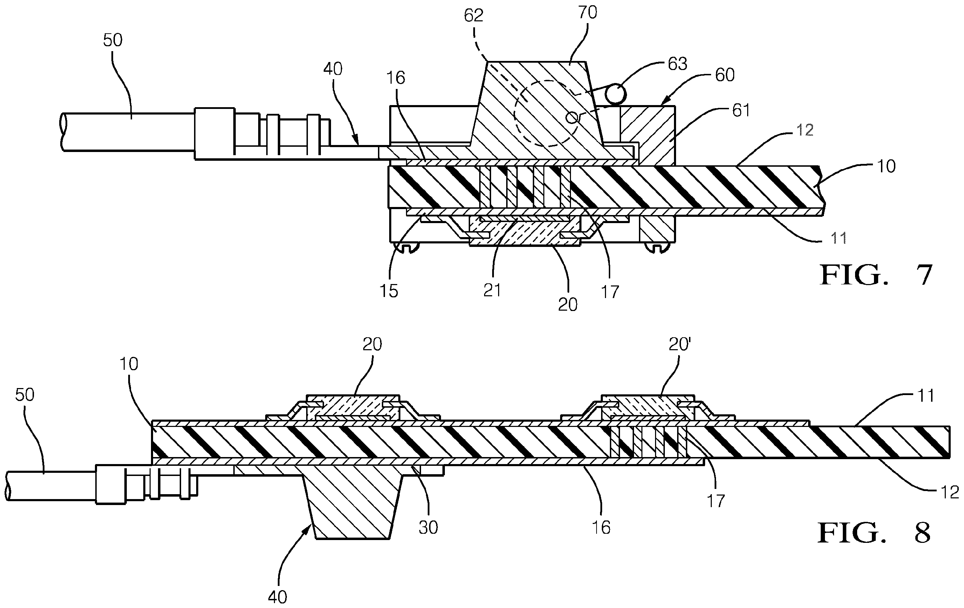

Figur 5 zeigt das Kontaktelement 40 mit dem daran befestigten elektrischen Leitern 50. Das Haltemittel 60 umfasst ein Klemmprofil 61 sowie ein Exzenter 62, an dem ein Hebel 63 angebracht ist. Die Funktionsweise des Haltemittels 60 ist aus Figur 7 ableitbar.

Figur 6A und 6B zeigen das Kontaktelement 40 in seitlichen Ansichten. Zu sehen ist der ebene Kontaktbereich 41 mit dem das Kontaktelement 40 das Verbindungsmittel 30 kontaktiert. Das Kontaktelement 40 verfügt in dieser Ausführungsform über Kühlmittel 70 in Form von Kühlrippen, die sich vom Kontaktbereich 41, entgegen des Kontaktbereichs 41, erstrecken. Im Anschlussbereich des Kontaktelements 40, der zur Verbindung mit einem Leitungssatz vorgesehen ist, ist mittels einer Crimp-Verbindung der elektrischer Leiter 50 angebracht. Es könnte allerdings jede bekannte Verbindungstechnik wie, Schraubverbindungen, Löt-oder-Schweißverbindungen, verwendet werden.

Figur 7 zeigt eine Ausführungsform der Erfindung in Schnittdarstellung. Das Kontaktelement 40, mit dem daran befestigtem elektrischen Leiter 50, wird mittels des Haltemittels 60 auf die zweite leitfähige Beschichtung 16 der Leiterplatte 10 gedrückt und so über das Verbindungsmittel 30 elektrisch kontaktiert. Das Kontaktelement 40 und das Verbindungsmittel 30 befinden sich auf der zweiten Seite 12 der Leiterplatte 10, gegenüber dem Halbleiterbauelemente 20, das auf der ersten Seite 11 angebracht ist. Das Verbindungsmittel 30 weist Durchkontaktierungen 17 auf, die sich durch die Leiterplatte 10 hindurch, von der ersten leitfähigen Beschichtung 15 zur zweiten leitfähigen Beschichtung 16 erstrecken und diese miteinander verbinden. Das Halbleiterbauelement 20 weist einen Kontaktbereich 21 an der, der Leiterplatte zugewandten Seite, seines Körpers auf. Der Kontaktbereich 21 ist elektrisch mit der ersten leitfähigen Beschichtung 15 verbunden. Dieser Aufbau macht es möglich einen Strompfad, ausgehend von der elektrischen Leitung 50, bis zum Halbleiterbauelemente 20, mit niedrigem Widerstand zu realisieren. Außerdem bietet diese Anordnung die Möglichkeit, das Kontaktelement 40 und den elektrischen Leiter 50 als Kühlelemente zu benutzen, da sie sich in unmittelbarer Nähe, nur durch die Leiterplatte getrennt, an der Wärmequelle (Halbleiterbauelement) befinden. Durch die räumliche Nähe kann diese Anordnung effektiv kühlen.

Figur 8 zeigt einer Ausführungsform, bei der zwei Halbleiterbauelemente 20, 20' auf der ersten Seite 11, der Leiterplatte 10 angeordnet sind. Das Kontaktelement 40 ist an einer Position gegenüber dem ersten Halbleiterbauelemente 20 befestigt. Das Halbleiterbauelement 20 ist allerdings nicht dafür vorgesehen den Strom, der über den elektrischen Leiter 50 transportiert wird zu steuern. Das Kontaktelement 40 ist über die zweite leitfähige Beschichtung 16 mit dem zweiten Halbleiterbauelemente 20' elektrisch verbunden. Das zweite Halbleiterbauelement 20' steuert den Strom der durch den elektrischen Leiter 50 fließt. In dieser Ausführungsform wird ein Halbleiterbauelement 20 durch Auswahl der Position gegenüber dem Verbindungsmittel 30 und somit Kontaktelement 40 gekühlt, jedoch nicht mit Strom versorgt. Das zweite Halbleiterbauelement 20' wird mit Strom versorgt allerdings nicht vom Kontaktelement 40 gekühlt, da es sich nicht gegenüber dem Kontaktelement 40 befindet. Hierbei werden kleinere ausgleichende Wärmeflüsse in den leitfähigen Beschichtungen 15, 16 nicht berücksichtigt.

## Patentansprüche

1. Verbindungsanordnung (1) zum Übertragen großer elektrischer Ströme zum Betrieb von Elektrofahrzeugen, umfassend eine Leiterplatte (10), ein Halbleiterbauelement (20) angeordnet auf einer ersten Oberfläche (13) einer ersten Seite (11) der Leiterplatte (10), ein Verbindungsmittel (30) angeordnet auf einer zweiten Oberfläche (14) einer zweiten Seite (12) der Leiterplatte (10), sowie ein Kontaktelement (40) kontaktierbar mit dem Verbindungsmittel (30) und einer elektrischen Leitung (50) eines Kabelsatzes eines Elektrofahrzeugs, wobei das Verbindungsmittel (30) gegenüber dem Halbleiterbauelement (20) angeordnet ist, und wobei die erste Oberfläche (13) eine erste leitfähige Beschichtung (15) aufweist, **dadurch gekennzeichnet, dass** das Verbindungsmittel (30) aus einem Teil einer zweiten leitfähigen Beschichtung (16) der zweiten Oberfläche (14) gebildet ist.

2. Verbindungsanordnung (1) nach Anspruch 1, wobei das Halbleiterbauelement (20) und das gegenüberliegende Verbindungsmittel (30) beabstandet vom Rand der Leiterplatte (10) angeordnet sind.

3. Verbindungsanordnung (1) nach einem der vorhergehenden Ansprüche, wobei ein zweites Halbleiterbauelement (20') auf der ersten Oberfläche (13), der ersten Seite (11), der Leiterplatte (10) angeordnet ist und elektrisch direkt mit dem Kontaktelement (40) verbindbar ist.

4. Verbindungsanordnung (1), nach einem der vorhergehenden Ansprüche, wobei das Halbleiterbauelement (20), zumindest mit einem Teil der ersten leitfähigen Beschichtung (15), die sich zwischen dem Halbleiterbauelement (20) und Trägermaterial der Leiterplatte (10) erstreckt, elektrisch verbunden ist.

5. Verbindungsanordnung (1) nach Anspruch 1, wobei eine Fläche, des Verbindungsmittels (30) größer ist als eine Fläche der leitfähigen Beschichtung (15) der Leiterplatte (10), die zwischen Halbleiterbauelement (20) und Trägermaterial angeordnet ist.

6. Verbindungsanordnung (1) nach einem der vorhergehenden Ansprüche, wobei die Leiterplatte (10) im Bereich zwischen Halbleiterbauelement (20) und Verbindungsmittel (30), mindestens eine Durchkontaktierung (17) aufweist.

7. Verbindungsanordnung (1) nach einem der vorhergehenden Ansprüche, wobei das Kontaktelement (40) eine ebene Fläche (41) aufweist, die dazu ausgebildet ist mit dem Verbindungsmittel (30) eine elektrische Verbindung zu erzeugen.

8. Verbindungsanordnung (1) nach einem der vorhergehenden Ansprüche, wobei das Kontaktelement (40) Mittel zur Kühlung (70) aufweist.

9. Verbindungsanordnung (1) nach einem der vorhergehenden Ansprüche, wobei die Verbindungsanordnung Haltemittel (60) aufweist, die das Kontaktelement (40) und das Verbindungsmittel (30) lösbar zusammenhalten.

10. Verbindungsanordnung (1) nach Anspruch 9, wobei das Haltemittel (60), so ausgebildet ist, dass bei Betätigung des Haltemittels (60), das Kontaktelement (40) gegen das Verbindungsmittel (30) gedrückt wird und ein Teil des Haltemittels (60) gegen das Halbleiterbauelement (20) gedrückt wird.

11. Verbindungsanordnung (1) nach Anspruch 10 wobei das Haltemittel (60) im Querschnitt U-Förmig ist und an einem Schenkel ein Exzenter (62), angebracht ist, das in den Raum zwischen den Schenkeln, schwenkbar ist.

12. Verbindungsanordnung (1) nach Anspruch 9 bis 11, wobei das Haltemittel (60) Mittel zur Kühlung aufweist.

13. Verbindungsanordnung (1) nach einem der vorhergehenden Ansprüche, wobei die Verbindungsanordnung (1) für Hochstromanwendungen geeignet ist.

## Claims

1. A connection arrangement (1) for transmitting large electrical currents for the operation of electric vehicles, comprising a circuit board (10), a semiconductor component (20) arranged on a first surface (13) of a first side (11) of the circuit board (10), a connection means (30) arranged on a second surface (14) of a second side (12) of the circuit board (10), and a contact element (40) which can be contacted with the connection means (30) and with an electrical line (50) of a cable harness of an electric vehicle, wherein the connection means (30) is arranged opposite the semiconductor component (20), and wherein the first surface (13) has a first conductive coating (15), **characterized in that** the connection means (30) is formed from a portion of a second conductive coating (16) of the second surface (14).

2. A connection arrangement (1) in accordance with claim 1, wherein the semiconductor component (20) and the oppositely disposed connection means (30) are arranged spaced apart from the margin of the circuit board (10).

3. A connection arrangement (1) in accordance with one of the preceding claims, wherein a second semiconductor component (20') is arranged on the first surface (13), of the first side (11), of the circuit board (10) and is electrically directly connectable to the contact element (40).

4. A connection arrangement (1) in accordance with any one of the preceding claims, wherein the semiconductor component (20) is electrically connected to at least a portion of the first conductive coating (15), said first conductive coating (15) extending between the semiconductor component (20) and carrier material of the circuit board (10).

5. A connection arrangement (1) in accordance with claim 1, wherein a surface of the connection means (30) is larger than a surface of the conductive coating (15) of the circuit board (10) arranged between the semiconductor component (20) and carrier material.

6. A connection arrangement (1) in accordance with any one of the preceding claims, wherein the circuit board (10) has at least one via (17) in the region between the semiconductor component (20) and the connection means (30).

7. A connection arrangement (1) in accordance with any one of the preceding claims, wherein the contact element (40) has a planar surface (41) which is configured to generate an electrical connection with the connection means (30).

8. A connection arrangement (1) in accordance with any one of the preceding claims, wherein the contact element (40) has means for cooling (70).

9. A connection arrangement (1) in accordance with any one of the preceding claims, wherein the connection arrangement has holding means (60) which releasably hold together the contact element (40) and the connection means (30).

10. A connection arrangement (1) in accordance with claim 9, wherein the holding means (60) is configured such that, on the actuation of the holding means (60), the contact element (40) is pressed toward the connection means (30) and a portion of the holding means (60) is pressed toward the semiconductor component (20).

11. A connection arrangement (1) in accordance with claim 10, wherein the holding means (60) is U-shaped in cross-section and an eccentric portion (62) which is pivotable into the space between the limbs is attached to one limb.

12. A connection arrangement (1) in accordance with claims 9 to 11, wherein the holding means (60) has means for cooling.

13. A connection arrangement (1) in accordance with any one of the preceding claims, wherein the connection arrangement (1) is suitable for high-current applications.

## Revendications

1. Ensemble de connexion (1) pour la transmission de courants électriques élevés pour faire fonctionner des véhicules électriques, comprenant une carte à circuits (10), un composant semi-conducteur (20) disposé sur une première surface (13) d'une première face (11) de la carte à circuits (10), un moyen de connexion (30) disposé sur une deuxième surface (14) d'une deuxième face (12) de la carte à circuits (10), et un élément de contact (40) pouvant être mis en contact avec le moyen de connexion (30) et une ligne électrique (50) d'un jeu de câbles d'un véhicule électrique,
dans lequel
le moyen de connexion (30) est disposé en face du composant semi-conducteur (20), et
la première surface (13) présente un premier revêtement conducteur (15), **caractérisé en ce que**
le moyen de connexion (30) est formé d'une partie d'un deuxième revêtement conducteur (16) de la deuxième surface (14).

2. Ensemble de connexion (1) selon la revendication 1,
dans lequel
le composant semi-conducteur (20) et le moyen de connexion opposé (30) sont disposés en étant espacés du bord de la carte à circuits (10).

3. Ensemble de connexion (1) selon l'une des revendications précédentes,
dans lequel
un deuxième composant semi-conducteur (20') est disposé sur la première surface (13) de la première face (11) de la carte à circuits (10) et peut être connecté électriquement directement à l'élément de contact (40).

4. Ensemble de connexion (1) selon l'une des revendications précédentes,
dans lequel
le composant semi-conducteur (20) est connecté électriquement à au moins une partie du premier revêtement conducteur (15) qui s'étend entre le composant semi-conducteur (20) et le matériau porteur de la carte à circuits (10).

5. Ensemble de connexion (1) selon la revendication 1,
dans lequel
une surface du moyen de connexion (30) est supérieure à une surface du revêtement conducteur (15) de la carte à circuits (10), qui est disposée entre le composant semi-conducteur (20) et le matériau porteur.

6. Ensemble de connexion (1) selon l'une des revendications précédentes,
dans lequel
la carte à circuits (10) présente au moins un via (17) dans la zone entre le composant semi-conducteur (20) et le moyen de connexion (30).

7. Ensemble de connexion (1) selon l'une des revendications précédentes,
dans lequel
l'élément de contact (40) présente une surface plane (41) qui est réalisée pour engendrer une connexion électrique avec le moyen de connexion (30).

8. Ensemble de connexion (1) selon l'une des revendications précédentes,
dans lequel
l'élément de contact (40) comprend des moyens de refroidissement (70).

9. Ensemble de connexion (1) selon l'une des revendications précédentes,
dans lequel
l'ensemble de connexion comprend des moyens de retenue (60) qui maintiennent assemblés l'élément de contact (40) et le moyen de connexion (30) de façon détachable.

10. Ensemble de connexion (1) selon la revendication 9,
dans lequel
le moyen de retenue (60) est réalisé de telle sorte que lors de l'actionnement du moyen de retenue (60), l'élément de contact (40) est poussé contre le moyen de connexion (30) et une partie du moyen de retenue (60) est poussée contre le composant semi-conducteur (20).

11. Ensemble de connexion (1) selon la revendication 10,
dans lequel
le moyen de retenue (60) présente une section transversale en forme de U, et un excentrique (62) est monté sur une branche, qui peut être pivoté dans l'espace entre les branches.

12. Ensemble de connexion (1) selon les revendications 9 à 11,
dans lequel
le moyen de retenue (60) comprend des moyens de refroidissement.

13. Ensemble de connexion (1) selon l'une des revendications précédentes,
dans lequel
l'ensemble de connexion (1) est approprié pour des applications à courant élevé.
